# EUROPEAN PATENT APPLICATION

(11) **EP 1 602 624 A1**
(43) Date of publication of application: **07.12.2005**
(21) Application number: 04708917.2
(22) Date of filing: 06.02.2004
(51) Int. Cl.: B81B 3/00, B81C 1/00, G02B 26/00

(54) **MEMS ELEMENT AND METHOD OF PRODUCING THE SAME, AND DIFFRACTION TYPE MEMS ELEMENT**

(30) Priority: 17.02.2003 JP 2003038696
(71) Applicant: SONY CORPORATION, Tokyo 141-0001 (JP)
(72) Inventor: NANIWADA, Koji, c/o Sony Corporation, Shinagawa-ku, Tokyo 141-0001 (JP)
(74) Representative: Müller, Frithjof E.
(86) International application number: PCT/JP2004/001302
(87) International publication number: WO 2004/071942

(57) **Abstract**

The present invention provides a MEMS device in which a warp that is deformation of a beam is reduced and which aims to improve the characteristic thereof, a method for manufacturing the MEMS device and a diffraction-type MEMS device.

The MEMS device of the present invention includes a substrate-side electrode and a beam driven by a static electricity generated between the substrate-side and the beam, in which the beam is formed of a plurality of thin films including a driving-side electrode and is provided with deformation prevention means for preventing the deformation of the beam due to the warp of thin films caused by film stress.

The diffraction-type MEMS device of the present invention is configured such that in the above-described configuration the substrate-side electrode is made common and a plurality of beams are provided independently to each other so as to be opposed to the substrate electrode.

## Description

### TECHNICAL FIELD

This invention relates to a MEMS device and a method for manufacturing the same and a diffraction-type MEMS device.

### BACKGROUND ART

With the advancement of micro-fabrication technique, much attention has been focused on what is called a micro machine (MEMS: Micro Electro Mechanical Systems) device and a micro-sized device incorporated with a MEMS device.

The MEMS device is formed as a micro structure on a substrate such as silicon substrate, glass substrate or the like, in which a driving body outputting a mechanical driving force is electrically and further mechanically combined with a semiconductor integrated circuit or the like that controls the driving body. The fundamental characteristic of the MEMS device is that the driving body formed as a mechanical structure is incorporated in a part of the device and the driving body is electrically driven by a static electricity between electrodes, that is, an application of clone attraction or the like.

Conventionally, there have been developed optical MEMS devices that are applied to an optical switch, light modulation device or the like, by making use of light reflection or light diffraction. FIG. 11 shows a typical example of the optical MEMS device. An optical MEMS device 1 is configured such that a substrate-side electrode 3 with its surface covered with an insulation film 4 is formed on a silicon substrate 2, for example, and a beam 8 including a driving-side electrode 6 is supported to be opposed to the substrate-side electrode 3 with a space 5 in between. The beam 8 is formed of a laminated thin film including an insulation film, for example, a silicon nitride (SiN) film 7 and a driving-side electrode 6 that serves as a light reflective film as well, and is supported at its both ends by supports 9 formed of the same laminated thin film. The beam 8 is formed into what is called a both-end-supported beam structure. In the optical MEMS device 1, static electricity is generated between the substrate-side electrodes 3 and driving-side electrode 6 by voltage (electric signal) applied between both the electrodes 3 and 6, and the beam 8 is driven (vibrates) by static electricity to approach toward and depart from the substrate-side electrode 3 as indicated with a solid line and broken line.

Further, an optical MEMS device using reflected light can be applied as an optical switch having a switch function of detecting light reflected in one direction by making use of the fact that light incident on the surface of a beam reflects in different directions depending on positions where the beam are driven. Further, the optical MEMS device can be applied as a light modulation device for modulating the intensity of light. When using the light reflection, the intensity of light is modulated with the amount of reflected light in one direction per unit time by making a beam vibrate. This light modulation device is of what is called time modulation. Meanwhile, it is possible to modulate the intensity of light by using light diffraction. A light modulation device using light diffraction for modulating the intensity (diffraction intensity) of light reflected in the driving-side electrode is of what is called space modulation.

On the other hand, as an optical MEMS device applied to a light modulation device or the like, there has been proposed a diffraction-type MEMS device, that is, GLV (Grating Light Valve) device (refer to a Patent document 1).

The GLV device basically has such a configuration that a common substrate-side electrode is formed on a substrate, and a plurality of ribbon-shaped beams made of an insulation film and driving-side electrodes that also serve as a reflective film to cover the surface of the insulation film are formed through supports so as to be opposed to the substrate-side electrode with a space in between. With the GLV device, every other beam of the plurality of beams becomes a movable beam that approaches toward and departs from the substrate-side electrode by means of static electricity and the other beams become fixed beams. Then, every other beam out of six beams sinks to form a diffraction grating.

### [Patent document 1] Japanese Translation of PCT international application 2001-518198

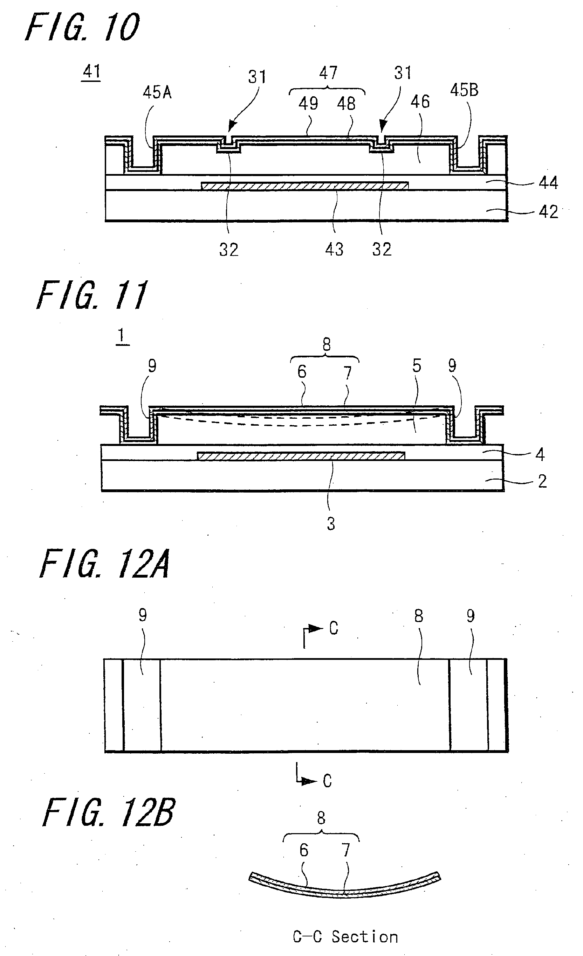

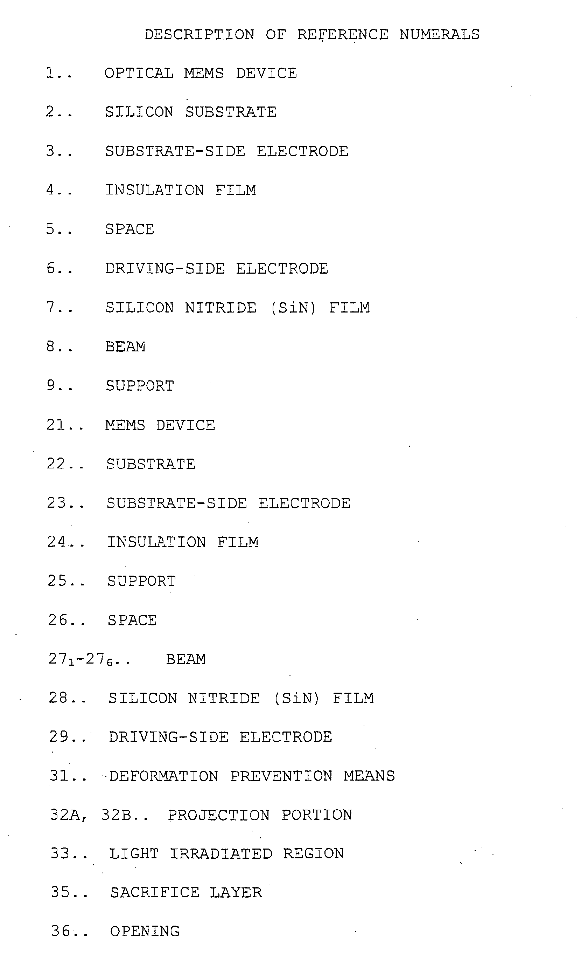

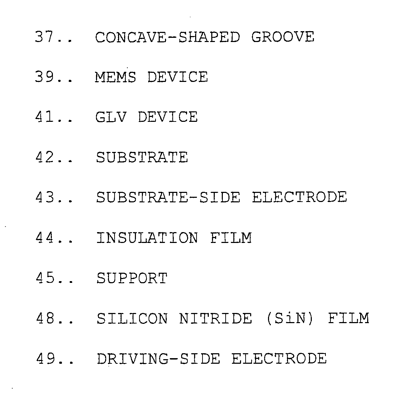

Hereupon, such MEMS device can be manufactured by using a semiconductor process. With the MEMS device formed of a beam structure using the semiconductor process, the shape of the beam becomes an important factor in determining the characteristic of the MEMS device. However, as shown in FIG. 12, deformation (warp) of the beam 8 occurs in a direction perpendicular to the direction that connects both the supports 9 (in the width direction).

The reason for that is as follows: with the MEMS device, a thin film has been used for a semiconductor process to make the shape of the beam, however, at a time of manufacturing the beam by laminating thin films of plural kinds of materials, or in the case of the illustrated example, at a time of manufacturing the beam by using a two-layer film of the silicon nitride (SiN) film 7 and Al driving-side electrode 6, when being separated from the substrate 2, the beam 8 warps and is deformed in the width direction due to the difference of film stress between the materials, that is, between Sin film 7 and Al film 6. The warp of the beam 8 has, in many cases, unfavorable effects on the characteristics of the MEMS device, particularly, on reflection efficiency and diffraction efficiency, and to reduce the warp has become a crucial issue.

In the meantime, with a technology to solve the above problem of the warp, a film made of a material to counteract the stress may be added to the beam; however, there is a limit to materials that can be used in the semiconductor process, and further, when a film of a different material is added, there has been a problem such as degradation of the characteristics of the MEMS device.

### DISCLOSURE OF THE INVENTION

The present invention provides a MEMS device in which a warp or deformation of a beam is reduced and characteristics are made to improve, a manufacturing method thereof and a diffraction-type MEMS device.

The MEMS device of the present invention includes a substrate-side electrode, a beam driven by static electricity generated between the substrate-side electrode and the beam, in which the beam is formed of a plurality of films including driving-side electrodes, and the beam is provided with deformation prevention means for preventing a deformation due to a warp caused by film stress.

The deformation prevention means is provided preferably in the vicinity of a light irradiated region of the beam and further, a plurality of the deformation prevention means are preferably provided with the light irradiated region in between. In the case of a both-end-supported beam structure, the deformation prevention means is preferably formed into an elongated shape in the direction perpendicular to the direction connecting both the fixed ends of the beam; in the case of a cantilever beam structure, the deformation prevention means is preferably formed into an elongated shape in the direction perpendicular to the direction connecting the fixed end of the beam and the free end that is opposed to the fixed end. In addition, the deformation prevention means are preferably formed into a projecting portion that projects toward the opposite surface side to become concave when seen from the light irradiated surface side of the beam.

In the MEMS device of the present invention, since the deformation prevention means is provided, the strength of the beam increases and the occurrences of the warp, that is, a deformation of the beam reduces.

The diffraction-type MEMS device of the present invention includes a common substrate-side electrode, a plurality of beams that are disposed in parallel independently to each other to be opposed to the common substrate-side electrode and are driven by static electricity generated between the common substrate-side electrode and the beam, in which the beam is formed of a plurality of films including driving-side electrodes and the beam is provided with deformation prevention means for preventing a deformation due to a warp caused by film stress.

Similarly to the above, the deformation prevention means are preferably disposed in the vicinity of the light irradiated region of the beams and a plurality of the deformation prevention means are preferably disposed with the light irradiated region in between. In the case of a both-end-supported beam structure, the deformation prevention means is preferably formed into an elongated shape in a direction perpendicular to the direction connecting both the fixed ends of the beam. In addition, the deformation prevention means is preferably formed into a projecting portion that projects toward the opposite surface side to become concave when seen from the light irradiated surface side of the beam.

In the diffraction-type MEMS device of the present invention, since the deformation prevention means is provided, the strength of the beam increases and the occurrences of the warp, that is, deformation of the beam reduces.

A method for manufacturing a MEMS device according to the present invention includes the steps of: forming a sacrifice layer on a substrate with a substrate-side electrode formed therein; boring an opening reaching down to the substrate at the position of the sacrifice layer where a support is to be formed; selectively removing the portions for forming deformation prevention means on the surface of said sacrifice layer; forming the support and a beam that are made of a plurality of thin films including a driving-side electrode on the surface of the sacrifice layer including the inner portions of the opening and the removed portions; and removing the sacrifice layer and forming the beam to integrate the support with deformation prevention means.

In the method for manufacturing the MEMS device of the present invention, since the portions on the surface of the sacrifice layer, where the deformation prevention means are to be formed, are selectively removed and the beam made of the plurality of thin films is formed including the removed portion, the beam integrated with the deformation prevention means are formed. Accordingly, the MEMS device provided with the beam not easily warped can be manufactured with ease and accuracy.

According to the MEMS device of the present invention, the warp that is deformation of the beam can be reduced and thereby the characteristics of the beam can be improved. A simulation based on the finite device method has confirmed that the warp in the beam can be reduced by 40% or more.

According to the diffraction-type MEMS device of the present invention, a warp, that is, deformation of each beam can be reduced while maintaining the tensile force of each beam and thereby optical characteristics can be improved. When providing the deformation prevention means in the vicinity of a light irradiated region of the beam, the planarity of the beams in the light irradiated region can be improved and further improvement of characteristics can be attained without incident light being interrupted by a projecting portion.

When the projecting portions are provided with a plurality of deformation prevention means with the light irradiated region in between, the warp in the light irradiated region of the beams can further be reduced.

In the case of the both-end-supported beam structure, the deformation prevention means is formed into an elongated shape in the direction perpendicular to the direction connecting both fixed ends of the beam and so the strength in the width direction of the beams can be improved and a warp can be reduced. Since both the ends are fixed, the warp in the longitudinal direction can almost be negligible. In the case of the cantilever beam structure, the deformation prevention means is formed into an elongated shape in the direction perpendicular to the direction connecting the fixed end of the beam and a free end opposing the fixed end, and so the strength in the width direction of the beams can be improved and a warp can be reduced.

By forming the deformation prevention means with the projecting portion that projects toward the opposite surface side into a concave shape when seen from the light irradiated region side, the warp in the beams can be reduced while maintaining the strength in the width direction thereof.

According to the method for manufacturing the MEMS device of the present invention, the above-mentioned MEMS device and diffraction-type MEMS device can be manufactured with ease and accuracy.

### BRIEF DESCRIPTION OF DRAWINGS

FIG. 1 is a constitutional diagram showing an embodiment of a MEMS device of the present invention;
FIG. 2A is a top view showing a beam of the MEMS device according to an embodiment of the present invention, FIG. 2B is a sectional view of FIG. 2A on the A-A line and FIG. 2C is a sectional view of FIG. 2A on the B-B line;
FIG. 3A is a dimensional diagram of a beam of the MEMS device according to an embodiment of the present invention and FIG. 3B is a sectional view of FIG. 3A on the D-D line;
FIG. 4 is a sectional structure diagram based on a result of simulation of the beam according to the present invention;
FIG. 5 is a sectional structure diagram based on a result of simulation of the beam according to an example of the related art;
FIGS. 6A₁ to 6C₁ are manufacturing process diagrams (first part) showing an embodiment of the MEMS device of the present invention, and FIGS. 6A₂ to 6C₂ are sectional views of FIGS. 6A₁ to 6C₁ on the E-E line;
FIGS. 7A₁ to 7C₁ are manufacturing process diagrams (second part) showing an embodiment of the MEMS device of the present invention, and FIGS. 7A₂ to 7C₂ are sectional views of FIGS. 7A₁ to 7C₁ on the E-E line;
FIG. 8 is a sectional diagram showing another embodiment (cantilever beam structure) of the MEMS device of the present invention;
FIG. 9 is a constitutional diagram showing an embodiment of a GLV device, that is, diffraction-type MEMS device of the present invention;
FIG. 10 is a sectional diagram showing the diffraction-type MEMS device of FIG. 9;
FIG. 11 is a sectional diagram showing a conventional optical MEMS device; and
FIG. 12A is a top view showing a conventional MEMS device and FIG. 12B is a sectional view of FIG. 12A on the C-C line.

### BEST MODE FOR CARRYING OUT THE INVENTION

Hereinafter, embodiments of the present invention will be explained with reference to drawings:

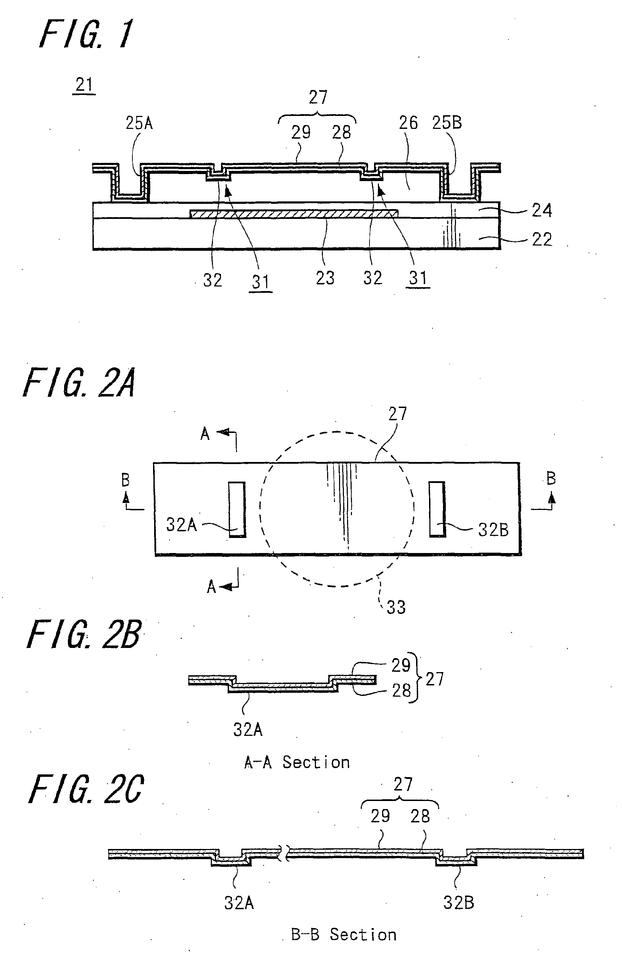

FIG. 1 shows an embodiment of a MEMS device of the present invention. A MEMS device 21 of the present invention includes a substrate-side electrode 23 formed on a substrate 22, an insulation film 24 that serves as a protective film as well formed on the substrate-side electrode 23, and a beam 27 formed to be opposed to the substrate-side electrode 23 with a space 26 in between such that the both ends thereof are supported by supports 25 [25A, 25B]. The beam 27 is formed of a plurality of thin films of different materials including a driving-side electrode 29. In this embodiment, the rectangular ribbon-shaped beam 27 of a two-layer film structure is formed with a thin insulation film, for example, with a silicon nitride film 28 and the driving-side electrode 29 of a metal thin film made thereon. The driving-side electrode 29 also serves as a reflective film for reflecting incident light. The supports 25 in this embodiment are formed of the same two-layer film made of the thin insulation film 28 and thin metal film 29 as is the beam 27.

Further, in this embodiment, there is provided deformation prevention means 31 in a part of the beam 27, for preventing a deformation or warp due to a stress of thin films constituting the beam 27. The deformation prevention means 31 can be formed of a projecting portion 32 that is projected such that part of the beam 27 is pushed out. In theory, the projecting portion 32 may be projected toward the side of the thin insulation film 28 or the side of the driving-side electrode 29. However, it is preferably projected toward the side of the thin insulation film 28. Specifically, the projecting portion 32 is formed such that the opposite surface side (that is, the thin insulation film 28 side) projects to become a concave-state when seen from the light irradiated side of the beam 27. The reason is that the planarity of the driving-side electrode 29 that also serves as a reflective film needs to be secured, as described later on (to be explained in the manufacturing process).

The projecting portion 32 that becomes the deformation prevention means 32 is disposed in the vicinity of the light irradiated region 33, as shown in FIGS. 2A to 2C, for the purpose of particularly securing the planarity of the reflective surface of a light irradiated region 33. In addition, a plurality of the projecting portions 32 are provided with the light irradiated region 33 in between. In this embodiment, two projecting portions 32A, 32B are provided with the light irradiated region 33 in between. Further, the projecting portions 32 are formed into an elongated shape in the direction perpendicular to the direction connecting the both ends, which are supported by both supports 25 [25A, 25B], of the beam 27, for example, in this embodiment, in the short-side direction perpendicular to the ribbon-shaped longitudinal direction of the beam. The projecting portions 32 are, as is obvious from what have been described above, formed not to cross the beam 27 in the short-side direction, but to stay within the beam 27, which is to maintain the tensile force of the beam 27.

With the MEMS device 21 of this embodiment, by applying required voltage (electric signal) between the substrate-side electrode and driving-side electrode, as described above, static electricity occurs between both the electrodes 23, 29 and then, the beam 27 is driven (vibrates) to approach toward and depart from the substrate-side electrode 23 by on and off control. The MEMS device 21 is applied to a light modulation device, optical switch and the like in which modulation in reflected light, diffracted light, or reflection direction and the like of light incident on the beam 27 due to displacement of the beam 27 is used.

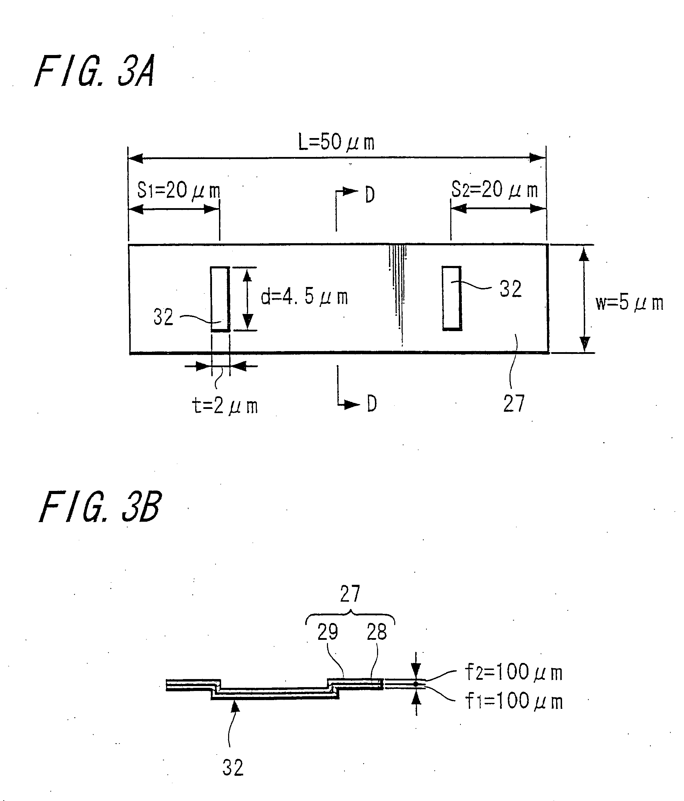

FIGS. 3A and 3B show an example of specific dimensions of the beam 27 in the MEMS device 21 of the embodiment shown in FIGS. 1 and 2. The beam 27 is rectangular having the whole length L of approximately 50µm in the longitudinal direction and the length W of approximately 5µm in the width direction, and the projecting portions 32, that is, two deformation prevention means 31 are disposed at positions where distances S₁, S₂ from the both ends in the longitudinal direction are 20µm or so, respectively. The projecting portion is formed into an elongated square with a length t of 2µm in parallel with the longitudinal direction of the beam 27 and a width of 4.5µm in parallel with the width direction of the beam 27. In the two-layer structure beam 27, a film thickness f₁ of the silicon nitride film 28 is approximately 100µm and a film thickness f₂ of the driving-side electrode 29, for example, Al film is approximately 100µm.

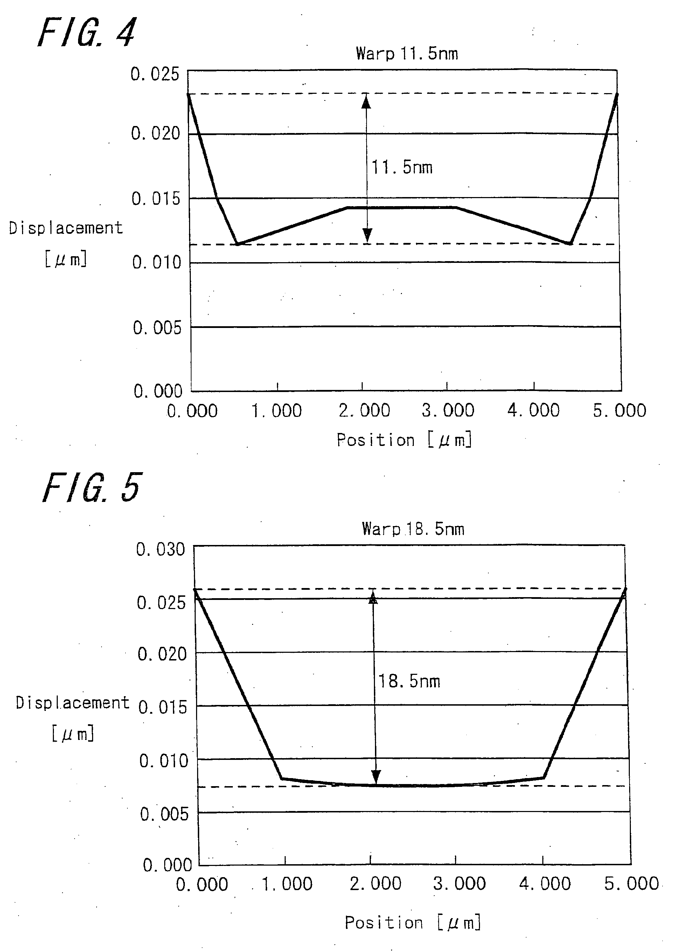

FIG. 4 shows a deformed state of the beam 27 (refer to FIG. 3) of the MEMS device according to this embodiment, and FIG. 5 shows a deformed state of a beam 8 of a conventional MEMS device (refer to FIGS. 11 and 12) for comparison. Shape and dimensions of the beam 27 and 8 are equivalent to those of FIG. 3. Results of calculations by the simulator in FIGS. 4 and 5 are all obtained at a cross section on the D - D line in FIG. 3.

With respect to the results of calculation in a conventional example in FIG. 5, a large displacement, that is, a drop of approximately 18.5 µm is recognized in the middle region ranging from 1 µm to 4 µm. Specifically, it is understood that the beam 8 warps and is deformed approximately at the center in the width direction. The so-called warp is 18. 5 nm. On the other hand, with respect to the calculation results of this embodiment shown in FIG. 4, a displacement, that is, a drop of approximately 11.5 nm (the so-called warp is 11.5 nm), is recognized in the middle region ranging from 0.5 µm to 4.5 µm. It is, however, understood that the drop of displacement was reduced by 38% compared with the above-described conventional example of FIG. 5.

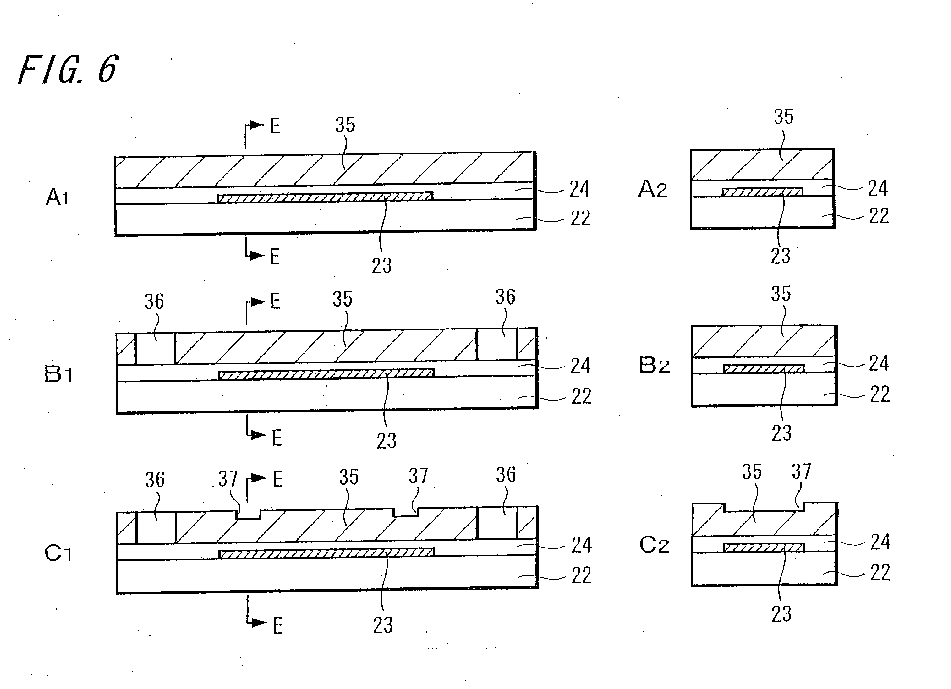

Next, a method for manufacturing the MEMS device 21 of the above-mentioned embodiment will be explained with reference to FIGS. 6 to 7. Hereupon, FIG. 6A₂ is a sectional view on the E-E line of FIG. 6A₁ and this relation is also the same with respect to the following diagrams.

First, as shown in FIGS. 6A₁ and 6A₂, there is prepared a substrate, for example, a substrate in which an insulative film is formed on a semiconductor substrate made of, for example, silicon (Si) and gallium arsenic (GaAs), or a substrate such as a quartz substrate or glass substrate. In this embodiment, a silicon substrate is used and a required conductive film, in this embodiment, a substrate-side electrode 23 made of polycrystal silicon film is formed on a substrate 22 with an insulation film formed on the silicon substrate, and further an insulation film 24, for example, a silicon oxide (SiO₂) film is formed to cover the substrate-side electrode 23. Subsequently, a sacrifice layer 35, in this case, an amorphous silicon film is deposited on the whole surface.

Next, as shown in FIGS. 6B₁ and 6B₂, a resist mask (not shown) is formed on the sacrifice layer 35, and portions corresponding to the positions at which supports of the sacrifice layer 35 are to be formed are selectively etched and removed through the resist mask to thereby form openings 36 reaching the insulation film 24 on the substrate 22 side.

Next, as shown in FIGS. 6C₁ and 6C₂, a resist mask (not shown) is again formed on the sacrifice layer 35, and portions corresponding to the positions at which deformation prevention means on the surface of the sacrifice layer 35 are to be formed are selectively etched and removed through the resist mask to thereby form two concave-shaped grooves 37.

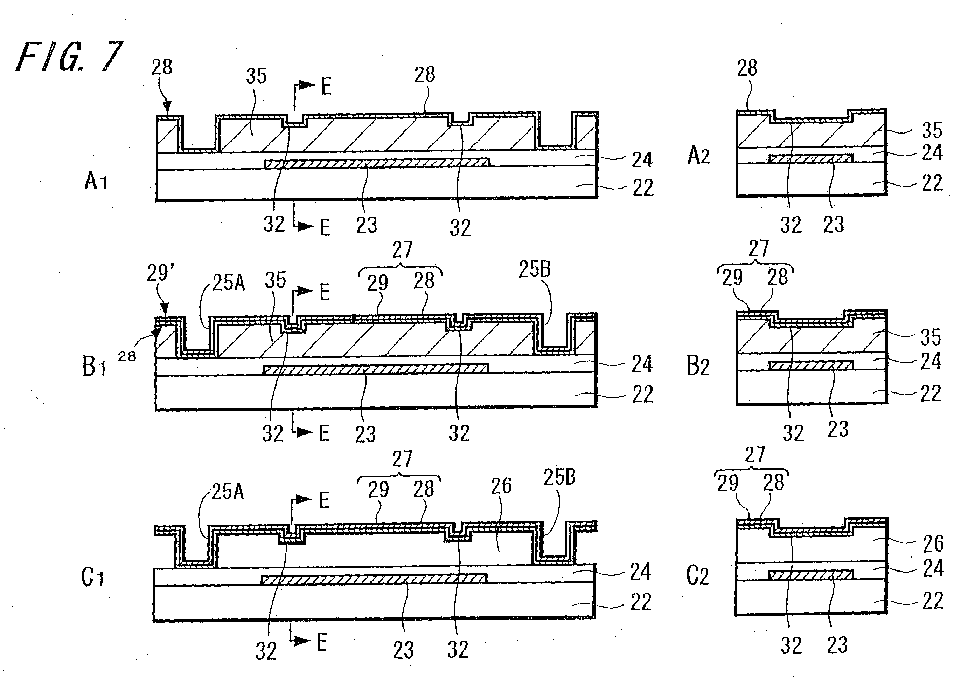

Next, as shown in FIGS. 7A₁ and 7A₂, an insulation layer, in this embodiment, silicon nitride (SiN) film 28 is deposited on the whole surface of the sacrifice layer 35 including the inner portions of the openings 36 and concave-shaped grooves 37. As described later on, the silicon nitride (SiN) film 28 buried into the inner portions of the openings 36 corresponds to the supports and the silicon nitride (SiN) film 28 buried into the concave-shaped grooves 37 corresponds to the deformation prevention means.

Next, as shown in FIGS. 7B₁ and 7B₂, a thin metal film to be a driving-side electrode (serving as a reflective film as well), in this embodiment, a thin metal film 29' of which aluminum is a main component (hereinafter, referred to an Al film for convenience' sake) is deposited on the whole surface of the silicon nitride film 28. As a thin metal film, of which aluminum is a main component, for example, Al-Si, Al-Cu, Al-Si-Cu, Al-Hf, Al-Zr or the like may be used. Next, the Al film 29' and silicon nitride film 28 are etched and removed to become patterns corresponding to the beam and supports. As a result, the beam 27 of a two-layer film structure including the silicon nitride film 28 and driving-side electrode 29 made of Al film, as well as a pair of the supports 25 [25A, 25B] to support both the ends of the beam 27 are formed.

Next, as shown in FIGS. 7C₁ and 7C₂, the sacrifice layer is etched and removed. As a result, the objective MEMS 21 is obtained, in which the beam 27 opposed to the substrate-side electrode 23 with the space 26 in between is supported by the supports 25 [25A, 25B], and the two projecting portions 32 that become the deformation prevention means 31 are integrally formed with the beam 27.

In the manufacturing method of this embodiment, when forming the projecting portions 32 in the process of FIGS. C₁ and C₂, parts of the surface of the sacrifice layer 35 are selectively removed to form the concave-shaped grooves 37 to be the projecting portions 32 that project toward the rear surface on the substrate side of the beam 27. Typically, an etched surface deteriorates with respect to planarity when compared with the surface that is deposited with the CVD (chemical vapor deposition) method or the like. Accordingly, the surface planarity of the silicon nitride film 28 and the Al film that becomes driving-side electrode 29 deposited on the surface of the sacrifice layer 35 by this method are improved, and the beam 27 with a reflective surface having excellent planarity can be formed.

According to the manufacturing method of this embodiment, the MEMS device 21 including the beam 27 that is resistant to deformation (warp) can be manufactured with ease and accuracy by using the semiconductor process.

According to the MEMS device 21 of this embodiment, by providing the projecting portions 32, that is, the deformation prevention means 31 in the beam 27, the strength of the beam 27 improves, thereby reducing the beam deformation, that is, making the beam 27 resistant to the warp. As a result, the optical characteristics of the MEMS can be improved, that is, become excellent. Simulation using the finite device method confirmed that the warp of the beam had been reduced by 40% or more. For example, it is confirmed that the warp had decreased from 15nm to 6nm.

Since the projecting portions 32 are provided in the vicinity of the light irradiated region 33 of the beam 27, the beam planarity in the light irradiated region 33 can be improved and since incident light is not interrupted by the projecting portions 32, further improvement of the characteristics thereof can be implemented. Particularly, when providing the two projecting portions 32 with the light irradiated region in between, the warp in the light irradiated region of the beam 27 can further be decreased.

In addition, by forming the projecting portions 32 into an elongated shape in the direction perpendicular to the longitudinal direction of the beam 27, the strength in the width direction of the beam can increase, thereby reducing the warp. In the case of the beam 27 with the above-mentioned both-end-supported beam structure, since the both ends are fixed, the warp in the longitudinal direction can almost be negligible. Since the projecting portions 32 are formed on the beam 27 within the width thereof, the tensile force of the beam 27 can be maintained.

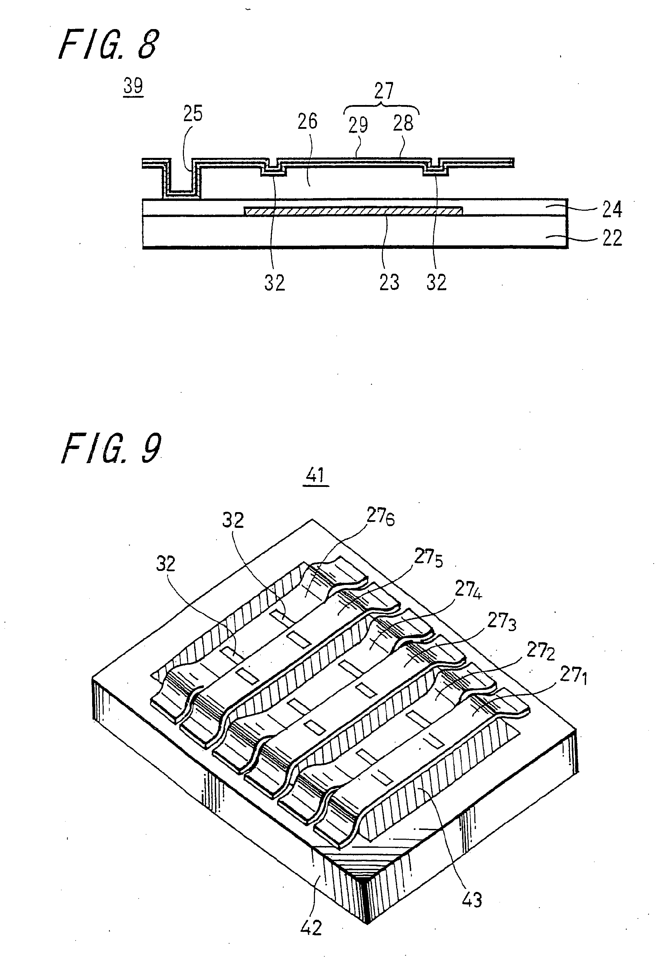

The present invention can also be applied to the MEMS device with cantilever beam structure. FIG. 8 shows an embodiment of a typical example.

A MEMS device 39 according to this embodiment includes the substrate-side electrode 23 formed on the substrate 22, the insulation film 24 also serving as a protective film formed on the substrate-side electrode 23, and the beam 27 formed to be opposed to the substrate-side electrode 23 with the space 26 in between such that one end of the beam 27 is supported by the support 25. Similarly to the above-mentioned embodiment, the beam 27 is formed of a plurality of thin films of different materials including the driving-side electrode, in this case, a two-layer film structure including the silicon nitride film 28 and driving-side electrode 29 made of a thin metal film thereon. The driving-side electrode 29 also serves as the reflective film to reflect the incident light. The support 25 is formed of the two-layer film made of the thin insulation film 28 and metal thin film 29 as is the beam 27. Further, two projecting portions 32 that serve as the deformation prevention means 31 are provided in parts of the beam 27. These projecting portions 32 are formed into an elongated shape in the direction perpendicular to the direction connecting the fixed end of the beam 27 and the free end that is opposed to the fixed end. Since the other structures are the same as those in FIG. 1, duplicate explanations will be omitted.

In the MEMS device 39 according to this embodiment, similarly to the above embodiment, the strength in the width direction of the beam 27 also increases, the warp in the width direction of the beam 27 can be reduced, and optical characteristics thereof can be improved.

In the above-mentioned embodiments, the film structure of the beam 27 was configured to have two-layers including the silicon nitride film 28 and driving-side electrode 29. Other than that, the present invention can be applied to a beam of laminated films,-that is, having two films or more.

FIGS. 9 and 10 show an embodiment in which the above-mentioned MEMS device in FIG. 1 is applied to the GLV device that is a diffraction-type MEMS device using diffraction light.

A GLV device 41 of this embodiment includes a common substrate-side electrode 43, with its surface covered with an insulation film 44, formed on a substrate 42, and a plurality of, in this case six ribbon-shaped, beams 27 [27₁, 27₂, 27₃, 27₄, 27₅, 27₆] of a two-layer structure made of an insulation film, in this case, of a silicon nitride (SiN) film 48 and driving-side electrode 49 made of metal thin film, formed through supports 45 [45A, 95B] to be opposed to the substrate-side electrode 43, with a space in between. Further, in this embodiment, particularly the same projecting portions 32 as FIG. 1 to be the deformation prevention means 31 are formed in the respective beams [27₁ to 27₆]. Since the structure of the projecting portions 32 is the same as that explained in FIG. 1, duplicate explanations will be omitted.

In the GLV device 41, every other beams 27₁, 27₃, 27₅ among a plurality of the beams 27 serve as movable beams that approach toward and depart from the substrate-side electrode 43 by means of a static electricity and the other beams 27₂, 27₄, 27₆ serve as fixed beams. FIG. 9 shows a state in which every other beams 27₁, 27₃, 27₅ are attracted toward the substrate-side electrode 43. At this time, every other beams of the six beams 27 sink to thereby form a diffraction grating.

In the GLV device 41, the difference between the phase of light reflecting on the surface of the movable beams 27₁, 27₃, 27₅ and that of light reflecting on the fixed beams 27₂, 27₄, 27₆ can be controlled digitally to be 0 or λ/4 or can be controlled in analog manner in the range of 0 to λ/4. For example, when the six beams 27 [27₁ to 27₆] form the same planar surface, reflected light on the surface of the beam 27 is a zero-order light. On the other hand, as shown in FIG. 9, when every other beam 27 sinks, there occurs ± first-order light due to diffraction. The GLV device 41 is applied as the optical modulation device in which the ± first-order light is added and used to modulate the intensity (diffraction intensity) of light reflected on the driving-side electrode 6 in accordance with light diffraction.

In the case of the GLV device 41 of this embodiment, since the projecting portions 32 are provided in the respective beams 27 similarly to the above mentioned embodiments, the strength of the beam 27 increases, which reduces the warp, that is, the deformation of the beam 27 while maintaining the tensile force and to further improve the optical characteristic of the GLV device 41.

## Claims

1. A MEMS device comprising: a substrate-side electrode and a beam driven by static electricity generated between the substrate-side electrode and the beam,
wherein said beam is formed of a plurality of films including a driving-side electrode and said beam is provided with deformation prevention means for preventing the deformation of the beam due to a warp caused by stress of said films.

2. A MEMS device according to claim 1,
wherein said deformation prevention means is provided in the vicinity of a light irradiated region.

3. A MEMS device according to claim 1,
wherein a plurality of said deformation prevention means are provided with the light irradiated region in between.

4. A MEMS device according to claim 1,
wherein said deformation prevention means is formed into an elongated shape in the direction perpendicular to the direction connecting fixed ends of said beam.

5. A MEMS device according to claim 1,
wherein said deformation prevention means is formed into an elongated shape in the direction perpendicular to the direction connecting said fixed end and a free end opposed to the fixed end.

6. A MEMS device according to claim 1,
wherein said deformation prevention means is formed of a projection portion projecting toward the opposite surface side to be a concave shape when seen from the light irradiated surface side of said beam.

7. A diffraction-type MEMS device comprising: a common substrate-side electrode, and a plurality of beams disposed in parallel independently to each other opposing said common substrate-side electrode and driven by static electricity generated between the common substrate-side electrode and the beam,
wherein said beam is formed of a plurality of films including driving-side electrodes and said beam is provided with deformation prevention means for preventing the deformation of the beam due to a warp caused by stress of said films.

8. A diffraction-type MEMS device according to claim 7,
wherein said deformation prevention means is provided in the vicinity of a light irradiated region.

9. A diffraction-type MEMS device according to claim 7,
wherein a plurality of said deformation prevention means are provided with the light irradiated region in between.

10. A diffraction-type MEMS device according to claim 7,
wherein said deformation prevention means are formed into an elongated shape in the direction perpendicular to the direction connecting both ends of said beam.

11. A method for manufacturing a MEMS device, comprising the steps of:
forming a sacrifice layer on a substrate in which a substrate-side electrode is formed;
boring an opening reaching down to said substrate at the position of said sacrifice layer, where a support is to be formed;
selectively removing portions for forming deformation prevention means on the surface of said sacrifice layer;
forming the support and a beam that are made of a plurality of thin films including a driving-side electrode on the surface of said sacrifice layer including the inner portions of said opening and said removed portions; and
removing the sacrifice layer and forming the beam with which the support and deformation prevention means are integrated.
